(19) Europäisches Patentamt / European Patent Office / Office européen des brevets

(11) **EP 3 555 848 B1**

(12) **FASCICULE DE BREVET EUROPEEN**

(45) Date de publication et mention de la délivrance du brevet:
**19.05.2021 Bulletin 2021/20**

(51) Int Cl.:
***G06T 7/00*** *(2017.01)*

(21) Numéro de dépôt: **17822609.8**

(22) Date de dépôt: **12.12.2017**

(86) Numéro de dépôt international:
**PCT/EP2017/082427**

(87) Numéro de publication internationale:
**WO 2018/108912 (21.06.2018 Gazette 2018/25)**

(54) **PROCÉDÉ DE MISE EN OEUVRE D'UNE TECHNIQUE DE CARACTÉRISATION CD-SEM**

VERFAHREN ZUR IMPLEMENTIERUNG EINER CD-SEM-CHARAKTERISIERUNGSTECHNIK

METHOD FOR IMPLEMENTING A CD-SEM CHARACTERISATION TECHNIQUE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.12.2016 FR 1662509**

(43) Date de publication de la demande:
**23.10.2019 Bulletin 2019/43**

(73) Titulaire: **Commissariat à l'Énergie Atomique et aux Énergies Alternatives 75015 Paris (FR)**

(72) Inventeurs:
• **QUEMERE, Patrick 38340 Voreppe (FR)**
• **HAZART, Jérôme 38320 Eybens (FR)**

(74) Mandataire: **Cabinet Camus Lebkiri 25 rue de Maubeuge 75009 Paris (FR)**

(56) Documents cités:
**FR-A1- 3 009 863**

• **CARL GEORG FRASE ET AL: "CD characterization of nanostructures in SEM metrology", MEASUREMENT SCIENCE AND TECHNOLOGY, IOP, BRISTOL, GB, vol. 18, no. 2, 1 février 2007 (2007-02-01), pages 510-519, XP020118520, ISSN: 0957-0233, DOI: 10.1088/0957-0233/18/2/S26 cité dans la demande**
• **NAOKI YASUI ET AL: "Application of model-based library approach to photoresist pattern shape measurement in advanced lithography", SPIE - INTERNATIONAL SOCIETY FOR OPTICAL ENGINEERING. PROCEEDINGS, vol. 7638, 11 mars 2010 (2010-03-11), pages 76382O-1, XP055395427, US ISSN: 0277-786X, DOI: 10.1117/12.846504 ISBN: 978-1-5106-0753-8**
• **LEVI SHIMON ET AL: "SEM simulation for 2D and 3D inspection metrology and defect review", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9051, 26 mars 2014 (2014-03-26), pages 90510B-90510B, XP060031041, DOI: 10.1117/12.2049337 ISBN: 978-1-62841-730-2 cité dans la demande**

EP 3 555 848 B1

**Description**

**DOMAINE**

La présente invention concerne le domaine de la métrologie dimensionnelle et a pour objet un procédé de mise en œuvre d'une technique de caractérisation par microscopie à balayage d'électrons pour la détermination d'une dimension critique, dite technique CD-SEM. Les techniques CD-SEM sont aujourd'hui largement utilisées pour la caractérisation de structures micrométriques ou nanométriques comme, par exemple, les motifs utilisés dans les circuits imprimés en microélectronique.

**ETAT DE L'ART**

La caractérisation de structures de taille micrométrique ou nanométrique est aujourd'hui d'importance primordiale dans l'industrie des semiconducteurs, notamment en microélectronique, et plus généralement dans le domaine des nanotechnologies. Si l'on considère le cas de la microélectronique, la mesure précise et fiable des dimensions caractéristiques des nanostructures se rend nécessaire tout au long des différentes étapes du processus de production, à partir de la phase de recherche et développement jusqu'à la phase de production. De plus, la miniaturisation des composantes microélectroniques demande des outils de caractérisation toujours plus performants.

L'industrie des semiconducteurs définit la taille de ses produits en termes d'une taille caractéristique appelée dimension critique ou « critical dimension » (CD) en anglais. On entend par dimension critique la ou les dimensions critiques d'un motif représentant une ou plusieurs longueurs caractéristiques du motif qui s'avèrent critiques soit pour la maitrise du procédé de fabrication soit pour garantir les performances électriques du dispositif électronique final constitué desdits motifs. La mesure fiable de cette dimension critique est aujourd'hui l'un des enjeux principaux pour la microscopie électronique à balayage.

Lors de l'acquisition d'une image par microscopie électronique à balayage, un faisceau d'électrons, dit faisceau d'électrons primaires, balaye la surface d'un échantillon d'intérêt. Chaque point de la surface est identifiée par un couple de cordonnées spatiales par exemple les cordonnées cartésiennes (x,y). Les collisions entre électrons primaires et les atomes de l'échantillon produisent plusieurs phénomènes physiques qui peuvent être très complexes. Parmi ces phénomènes il y a l'émission d'électrons secondaires et l'émission d'électrons rétrodiffusés. Ces électrons sont captés par des détecteurs sélectifs à proximité de l'échantillon. En balayant point par point l'échantillon on parvient à la formation d'une image électronique reflétant les différentes formes et différents matériaux de l'échantillon. Dans ce qui suit on se référera aux différentes formes de l'échantillon et leurs différents matériaux comme à la structure de l'échantillon.

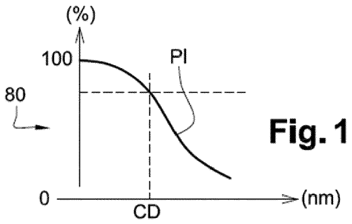

L'image SEM ainsi obtenue est une image en niveau de gris et les mesures géométriques des objets sont déterminées par une analyse des contours des objets obtenus après le choix d'un ou plusieurs seuils. On peut par exemple reconstruire un graphique comme illustré sur la figure 1 représentant un profil d'intensité d'électrons secondaires PI comportant en ordonnées un pourcentage d'électrons secondaires recueillis et en abscisse une dimension en nm représentative de la position de balayage. Mais un des problèmes majeurs est l'interprétation des images par des algorithmes à seuillage : c'est en effet le choix de ce seuil qui va déterminer la valeur de la taille caractéristique, ou dimension critique, d'intérêt. Or le choix du seuil est souvent arbitraire et le choix optimal est différent pour chaque objet, notamment en fonction de la hauteur des motifs, des matériaux en jeu, des dimensions des objets, de la densité de motifs, etc. D'autres types d'algorithmes sont basés non pas directement sur le niveau de gris mais sur l'analyse de la forme des pics d'intensité et le choix d'un seuil relatif à l'amplitude des pics. Là encore, le choix du seuil relatif à l'analyse du pic est empirique. Actuellement il est connu que les techniques CD-SEM donnent des mesures peu fiables pour des objets de taille inférieure à 100 nm (écart à la réalité du nanomètre à plusieurs nanomètres). Un seuil fixe empirique appliqué à tout type de motif est d'autant moins satisfaisant qu'il n'y a aucun lien physique direct entre le pourcentage d'électrons secondaires recueillis et la hauteur réelle du motif à laquelle on cherche à déterminer la dimension critique. En d'autres termes, si une mesure à 80% d'électrons secondaires est réalisée, ce n'est pas pour autant que l'on mesure une dimension critique à 80% de la hauteur du motif. Une analyse des images SEM avec un algorithme de seuillage peut donc très facilement fausser les mesures des dimensions critiques.

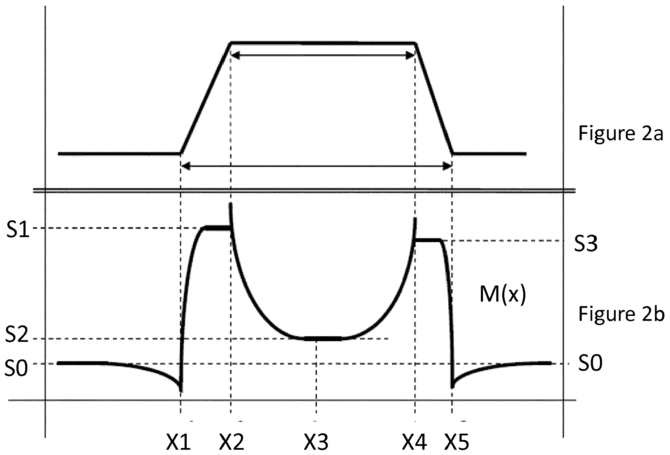

Pour remédier à ce problème, deux approches ont été envisagées. La première est basée sur des simulations physiques de type Monte Carlo. La mise en œuvre de cette méthode requiert la simulation des processus physiques d'interaction entre les électrons primaires du faisceau incident sur l'échantillon et l'échantillon luimême. La réalisation de ces simulations très complexes demande une grande puissance de calcul et des temps d'exécution très longs. Ces caractéristiques rendent les simulations physiques de type Monte Carlo généralement peu accessibles et très peu adaptées au traitement d'un grand nombre d'images CD-SEM. La seconde solution consiste à réaliser une modélisation mathématique paramétrique des images ; une telle solution est notamment décrite dans l'article « CD characterization of nanostructures in SEM metrology » (C. G. Frase, E. Buhr, et K. Dirscherl, Meas. Sci. Technol., vol. 18, n° 2, p. 510, février. 2007). Un exemple de telles fonctions est illustré en figure 2b pour un motif ayant un profil selon la direction x trapézoïdale, représenté en figure 2a. Ces fonctions peuvent être choisies selon un modèle phénoménologique simple ou bien par l'analyse de modélisations Monte-Carlo préliminaires décrivant la formation des images SEM (plus complexes et précises mais nécessitant des temps de calcul longs). Selon l'exemple de la figure 2, le motif est décomposé suivant des sections selon la direction x (ici six sections), chaque section correspondant à une fonction de forme particulière. La fonction *M(x)* peut ainsi se décomposer comme suit (en six fonctions selon chacune des sections) :

$$
M(x) := \begin{cases}
S0 + A e^{\frac{x-x1}{t0}} & x < x1 \\
S1 - (S1 - S0 - A)e^{-\frac{x-x1}{t1}} & x1 \leq x \leq x2 \\
S2 + C e^{\frac{x-x2}{t2}} & x2 < x \leq x3 \\
S2 + D e^{\frac{x-x4}{t3}} & x3 < x < x4 \\
S3 - (S3 - S0 - B)e^{\frac{x-x5}{t4}} & x4 \leq x \leq x5 \\
S0 + B e^{\frac{x5-x}{t5}} & x > x5
\end{cases}
$$

Chacune des six fonctions paramétriques reproduit la hauteur du profil de l'échantillon en fonction de la cordonnée x dans une certaine gamme de valeurs de x. Le modèle présenté ci-dessus comporte donc une pluralité de paramètres : $x_1$, $x_2$, $x_3$, $x_4$, $x_5$, $S_0$, $S_1$, $S_2$, $S_3$, $t_0$, $t_1$, $t_2$, $t_3$, $t_4$, $t_5$, A, B, C, D. L'existence de ce jeu de paramètres justifie l'appellation de fonction mathématique paramétrique. Souvent, pour des applications en métrologie dimensionnelle, les paramètres les plus intéressants sont ceux relatifs aux dimensions latérales du motif à savoir : $x_1$, $x_2$, $x_4$ et X5.

Une autre méthode de modélisation paramétrique des images CD-SEM est décrite dans l'article « Analytical Linescan Model for SEM Metrology » (C. A. Mack et B.D. Bunday, Metrology, Inspection and Process Control for Microlitography XXIX, Proc. SPIE Vol. 9424 2015). Selon ce modèle la fonction *M(x)* peut se décomposer comme suit :

$$
M(x) := \begin{cases}
S0.\left(1 - \alpha_f.e^{\frac{x}{\sigma_f}} - \alpha_b.e^{\frac{x}{\sigma_b}}\right) & x < x1 \\
S1 + \left(S0.\left(1 - \alpha_f - \alpha_b\right) - S1\right).e^{\frac{x}{d1}} + \left(S2.\left(1 + \alpha_e - \alpha_v\right) - S1\right).e^{-\frac{(X2-x)}{d2}} & x1 \leq x \leq x2 \\
S2 * \left(1 + \alpha_e.e^{\frac{X2-x}{\sigma_e}} - \alpha_v.e^{\frac{X2-x}{\sigma_v}}\right) & x > x2
\end{cases}
$$

Dans ce modèle les paramètres sont $S_0$, $S_1$, $S_2$, $\alpha_f$, $\alpha_b$, $\alpha_e$, $\alpha_v$, $\sigma_f$, $\sigma_b$, $\sigma_e$, $\sigma_v$, $d_1$, d2, X2.

De plus, pour tenir compte de la taille du faisceau d'électrons primaires, qui n'est pas nulle, il convient d'associer au profil décrit par *M(x)* un produit de convolution incluant dans le modèle les paramètres décrivant la taille et la forme du faisceau. Le plus souvent le profil du faisceau d'électrons primaires est caractérisé à l'aide d'un profil gaussien (« point spread fonction » ou PSF en anglais), le paramètre $\sigma_{PSF}$ étant proportionnel à la largeur à mi-hauteur de la gaussienne. Le modèle paramétrique ainsi modifié est calculé à l'aide de la formule suivante :

$$
M(x) = \int_{-\infty}^{+\infty} e^{-\frac{(x-x')^2}{2\sigma_{PSF}^2}} * M(x')dx'
$$

Dans la suite l'expression « jeu de paramètres du modèle théorique » se référera à l'ensemble des paramètres utilisés dans la formulation mathématique du modèle théorique. Parmi ces paramètres, certains sont utilisés dans la description géométrique de la structure de l'échantillon, d'autres décrivent la réponse instrumentale. Une fonction paramétrique telle que la fonction *M(x)* sera appelée dans la suite profil modèle ou profil paramétrique.

Un autre type de modélisation consiste à modéliser la probabilité d'émission d'un électron secondaire en fonction du matériau et la propagation de ces électrons vers les détecteurs en fonction de l'angle des détecteurs (voir par exemple les modèles de type AMAT, « SEM Simulation for 2D and 3D Inspection Metrology and Defect Review » de Shimon Levi, Ishai Schwarzband, Sergey Khristo, Yan Ivanchenko, Ofer Adan, Advances in Patterning Materials and Processes XXXI, 2014).

Des modèles plus simples ou plus complexes peuvent être élaborés en fonction du type d'échantillon, de la qualité des images, ou bien des informations a priori sur les matériaux ou les profils.

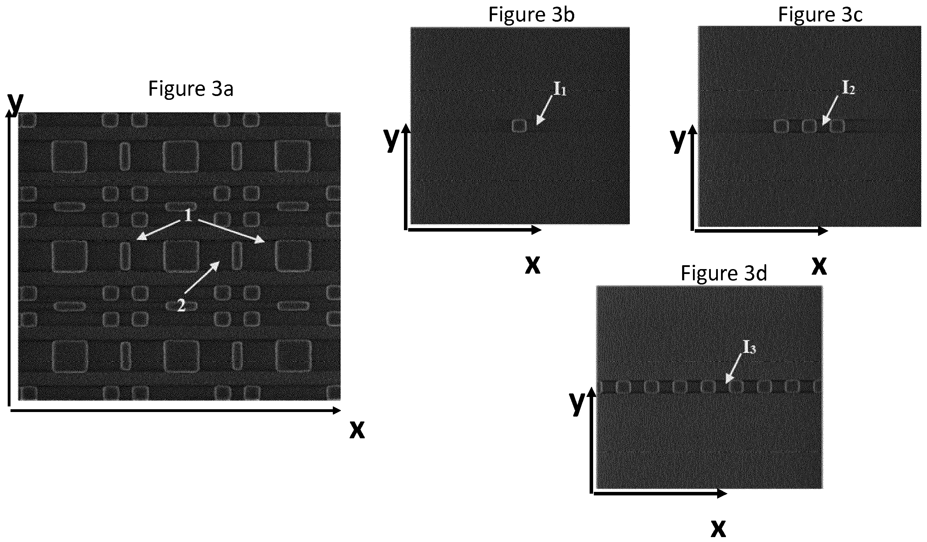

Une fois la modélisation terminée, il faut résoudre un problème inverse, à savoir l'ajustement des données expérimentales au modèle en faisant varier les paramètres. Une des limitations majeures de ces techniques est dans leur incapacité à prendre en compte et à reproduire certains artefacts observés sur les images CD-SEM. C'est par exemple le cas des images acquises en mode de balayage dit TV (ou « raster scan » en anglais). Ces images montrent des marques sombres dans les régions de la surface de l'échantillon comprises entre deux ou plusieurs structures voisines, comme les plots carrés ou rectangulaires de la figure 3a. Sur cette figure des directions x et y sont indiquées, la direction x étant celle de balayage et la direction y étant perpendiculaire à la direction x. Plus précisément ces marques sombres peuvent être classées suivant deux types :

- Des marques plutôt linéaires en gris foncé ou en noir dans le prolongement des arêtes horizontales alignées avec la direction de balayage et indiquées par le repère 1 de la figure 3a ;
- Des marques surfaciques en gris moins foncé le long des motifs, toujours dans la direction de balayage et indiquées par le repère 2 de la figure 3a.

Ces marques sombres sont des artefacts créés pendant le processus de formation de l'image.

On peut remarquer que la méthode des profils paramétriques ne rend compte que d'une modélisation des profils suivant la direction perpendiculaire aux arêtes et n'est donc pas en mesure de reproduire les effets de trainées noires présentes dans le prolongement des arêtes mêmes. Il est intéressant de noter que, comme illustré sur les figures 3b, 3c et 3d, la présence des trainées noires augmente quand plusieurs structures rapprochées sont présentes. Plus précisément, la figure 3b montre une structure carrée isolée. Des traces sombres sont visibles à gauche et à droite de la structure, indiquées par le repère $I_1$, avec des trainées noires dans le prolongement des arêtes horizontales. La figure 3c montre une image SEM de trois structures carrées rapprochées et alignées suivant la direction horizontale. Les marques sombres, indiquées par $I_2$, sont plus intenses que sur la figure 3b. La figure 3d montre une image SEM d'une série de plusieurs structures carrées. Les artéfacts de type marques sombres selon la direction de balayage, indiquées par $I_3$, sont cette fois plus intenses que sur les images 3b et 3c. Ces altérations ne peuvent pas être décrites suivant une vision purement locale comme celle des profils paramétriques.

## PROBLEME TECHNIQUE

Dans ce contexte, la présente invention a pour but d'améliorer l'exploitation des images CD-SEM obtenues expérimentalement par une technique CDSEM paramétrique.

## RESUME DE L'INVENTION

A cette fin, l'invention propose un procédé de mise en œuvre d'une technique de caractérisation par microscopie électronique à balayage pour la détermination d'au moins une dimension critique de la structure d'un échantillon dans le domaine de la métrologie dimensionnelle, dite technique CD-SEM, ledit procédé comportant les étapes suivantes :

- réalisation d'une image expérimentale représentative de la structure de l'échantillon et issue d'un microscope électronique à balayage ;
- à partir d'un premier modèle théorique basé sur des fonctions mathématiques paramétriques, calcul d'un second modèle théorique obtenu par somme algébrique d'un terme correctif, ledit terme correctif étant le produit de convolution entre un noyau de convolution donné et le premier modèle théorique, ledit second modèle théorique comportant un jeu de paramètres à déterminer ;
- détermination du jeu de paramètres présents dans le second modèle théorique au moyen d'un ajustement entre ledit second modèle théorique et ladite image expérimentale.

On entend par dimension critique (« critical dimension » en anglais) la ou les dimensions critiques d'un motif représentant une ou plusieurs longueurs caractéristiques du motif qui s'avèrent critiques soit pour la maitrise du procédé de fabrication soit pour garantir les performances électriques du dispositif électronique final constitué desdits motifs.

On entend par modèle théorique basé sur des fonctions paramétriques mathématiques une représentation mathématique de la structure de l'échantillon, par exemple par une des fonctions $M(x)$ définies précédemment et décrites en détail dans les articles « CD characterization of nanostructures in SEM metrology » (C. G. Frase, E. Buhr, et K. Dirscherl, Meas. Sci. Technol., vol. 18, n° 2, p. 510, février. 2007) ou « Analytical Linescan Model for SEM Metrology » (C. A. Mack et B.D. Bunday, Metrology, Inspection and Process Control for Microlitography XXIX, Proc. SPIE Vol. 9424 2015) ou AMAT par exemple.

On entend par jeu de paramètres présents dans le second modèle théorique l'ensemble des paramètres utilisés dans la formulation mathématique du second modèle théorique. Ce jeu de paramètres inclut à la fois les paramètres présents dans le premier modèle théorique paramétrique et les paramètres présents dans le terme correctif ajouté lors du calcul du second modèle théorique. Dans ce jeu de paramètres on aura certains paramètres décrivant la géométrie de la structure de l'échantillon, d'autres décrivant la réponse instrumentale.

On entend par ajustement entre le second modèle théorique et l'image expérimentale un procédé de calcul itératif visant à trouver le jeu de paramètres qui minimise l'écart entre ledit modèle et ladite image expérimentale. Dans la pratique, ce procédé de calcul est par exemple mis en œuvre par calculateur en choisissant un des algorithmes connus pour minimiser l'écart entre l'image expérimentale et le modèle théorique, suivant par exemple la méthode dite des moindres carrées.

De façon générale, l'invention consiste à obtenir les dimensions critiques de la structure de l'échantillon au moyen d'un ajustement entre une image expérimentale représentative de la structure de l'échantillon et un modèle théorique, ledit modèle théorique étant calculé de façon à prendre en compte les artefacts présents sur les images expérimentales.

Le but de l'invention est l'obtention plus efficace et plus précise des dimensions critiques.

Le procédé selon l'invention est un procédé de mise en œuvre d'une technique de caractérisation CD-SEM qui utilise une modélisation des images expérimentales, ladite modélisation étant capable de décrire, par exemple, les altérations de type variations d'intensité dans le prolongement des arêtes qui apparaissent sur les images. Ces altérations d'intensité sont le résultat de phénomènes qui ne peuvent pas être décrits suivant une vision purement locale comme celle des profils paramétriques. Parmi les phénomènes capables de produire de telles altérations on peut par exemple citer les effets d'accumulation de charge (« charging » en anglais). Ces charges électriques en excès produisent des champs électriques qui peuvent dévier les électrons (primaires et secondaires) et donc produire des baisses du flux d'électrons secondaires correspondant aux trainées noires visibles sur les figures 3a à 3d. Une modélisation plus complexe des images CD-SEM est donc requise.

Pour prendre en compte ces effets, le procédé selon l'invention modifie les modèles paramétriques en rajoutant par somme algébrique un terme correctif, ledit terme correctif étant un produit de convolution entre le modèle paramétrique même et un noyau de convolution donné. Grâce à la présence du produit de convolution, ce nouveau modèle permet de prendre en compte la densité d'arêtes ainsi que leur positionnement par rapport, par exemple, à la direction de balayage du faisceau d'électrons primaires. De plus, le choix du noyau de convolution permet d'adapter le procédé selon l'invention à une grande variété de motifs et de méthodes de balayage.

Le procédé selon l'invention peut également présenter une ou plusieurs des caractéristiques ci-dessous, considérées individuellement ou selon toutes les combinaisons techniquement possibles :

- le second modèle théorique est calculé selon la formule suivante :

$$Img(x,y) = G(x,y) - C \iint_{-\infty}^{+\infty} F(x',y') * [G(x',y') - \bar{G}_0]dx'dy'$$

dans laquelle :

$(x,y)$ sont les cordonnées spatiales associées à chaque point de l'image suivant les deux directions orthogonales x et y ;
$G(x,y)$ est le premier modèle théorique basé sur des fonctions mathématiques paramétriques ;
$Img(x,y)$ est le second modèle théorique obtenu par l'application du terme correctif;
$F(x, y)$ est le noyau de convolution donné ;
$\overline{G_0}$ est la moyenne (« background » en anglais) des intensités présentes sur l'image expérimentale ;
C est une constante d'ajustement ;

- le faisceau d'électrons primaires balaye la surface de l'échantillon suivant une ligne droite désignée axe x ou axe horizontale selon la méthode de balayage dite TV ou « raster scan » en anglais, la direction de balayage étant la direction horizontale ou axe x ;
- le noyau de convolution peut revêtir une forme mono-dimensionnelle symétrique, par l'intermédiaire par exemple d'une gaussienne portée selon l'axe x, ladite gaussienne ayant une largeur à mi-hauteur proportionnelle à sigma selon la formule suivante :

$$Img(x,y) = G(x,y) - C\int_{-\infty}^{+\infty} e^{-\frac{(x-x')^2}{2\sigma^2}} * [G(x',y) - \bar{G}_0]dx'$$

- le noyau de convolution peut revêtir une forme bidimensionnelle symétrique, par l'intermédiaire par exemple de deux gaussiennes portées respectivement par les axes x' et y' respectivement parallèle et normale à la direction de balayage du faisceau d'électrons primaires selon la formule suivante :

$$Img(x,y) = G(x,y) - C\iint_{-\infty}^{+\infty} e^{-\frac{(x-x')^2}{2\sigma_x{}^2}} e^{-\frac{(y-y')^2}{2\sigma_y{}^2}} * [G(x',y') - \bar{G}_0]dx'dy'$$

- le noyau de convolution peut revêtir une forme monodimensionnelle asymétrique suivant la direction de balayage du faisceau d'électrons primaires.
- le noyau de convolution peut revêtir une forme bidimensionnelle asymétrique suivant la direction de balayage du faisceau d'électrons primaires.
- le procédé est mis en œuvre pour calibrer la technique de caractérisation CD-SEM, ladite calibration comportant les étapes suivantes :

  - réalisation d'une image expérimentale représentative de la structure d'un échantillon de référence dont les dimensions géométriques sont connues, ladite image issue d'un microscope électronique à balayage ;
  - à partir d'un premier modèle théorique basé sur des fonctions mathématiques paramétriques, calcul d'un second modèle théorique obtenu par somme algébrique d'un terme correctif, ledit terme correctif étant le produit de convolution entre un noyau de convolution donné et le premier modèle théorique, ledit second modèle théorique comportant un jeu de paramètres, ledit jeu de paramètres comprenant à la fois les paramètres connus qui décrivent la structure géométrique de l'échantillon de référence et les paramètres à déterminer qui décrivent la réponse instrumentale ;
  - détermination des paramètres présents dans le second modèle théorique et décrivant la réponse instrumentale au moyen d'un ajustement entre ledit second modèle théorique et ladite image expérimentale représentative de la structure de l'échantillon de référence.

Le procédé de mise en œuvre d'une technique de caractérisation CD-SEM comporte avantageusement les étapes suivantes :

- réalisation d'une image expérimentale représentative de la structure de l'échantillon et issue d'un microscope électronique à balayage
- à partir d'un premier modèle théorique basé sur des fonctions mathématiques paramétriques, calcul d'un second modèle théorique obtenu par somme algébrique d'un terme correctif, ledit terme correctif étant le produit de convolution entre un noyau de convolution donné et le premier modèle théorique, ledit second modèle théorique comportant un jeu de paramètres, ledit jeu de paramètres comprenant à la fois les paramètres à déterminer qui décrivent la structure géométrique de l'échantillon d'intérêt et les paramètres déterminés par la calibration décrite ci-dessus qui décrivent la réponse instrumentale ;
- détermination des paramètres présents dans le second modèle théorique et décrivant la structure de l'échantillon d'intérêt au moyen d'un ajustement entre ledit second modèle théorique et ladite image expérimentale.

## LISTE DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- la figure 1 illustre schématiquement un profil d'intensité d'électrons secondaires en fonction du profil d'un motif obtenu via une instrumentation de type CD-SEM ;
- les figures 2a et 2b illustrent un exemple de modélisation mathématique paramétrique d'une image CD-SEM ;
- les figures 3a, 3b, 3c et 3d illustrent des exemples d'artefacts de type marques sombres observées sur des images CD-SEM expérimentales ;
- la figure 4 représente les différentes étapes du procédé selon l'invention ;
- la figure 5a représente une image CD-SEM ;

- la figure 5b représente un modèle théorique paramétrique de l'image 5a ;
- la figure 5c représente un modèle théorique de l'image 5a obtenu par application du procédé selon l'invention ;
- la figure 6a illustre la méthode de balayage dit TV (« raster scan » en anglais) ;
- la figure 6b illustre la méthode de balayage en dent de scie ;
- la figure 6c illustre la méthode de balayage bidirectionnelle ;
- la figure 6d illustre la méthode de balayage adaptée aux objets mesurés ;
- la figure 7a représente une image expérimentale CD-SEM
- la figure 7b montre un agrandissement d'une portion de la figure 7a illustrant un effet local particulier en correspondance d'un coin dans la structure de l'échantillon ;
- La figure 8 illustre un exemple de profil symétrique du noyau de convolution ;
- La figure 9 illustre un exemple de profil asymétrique du noyau de convolution.

## DESCRIPTION DETAILLEE

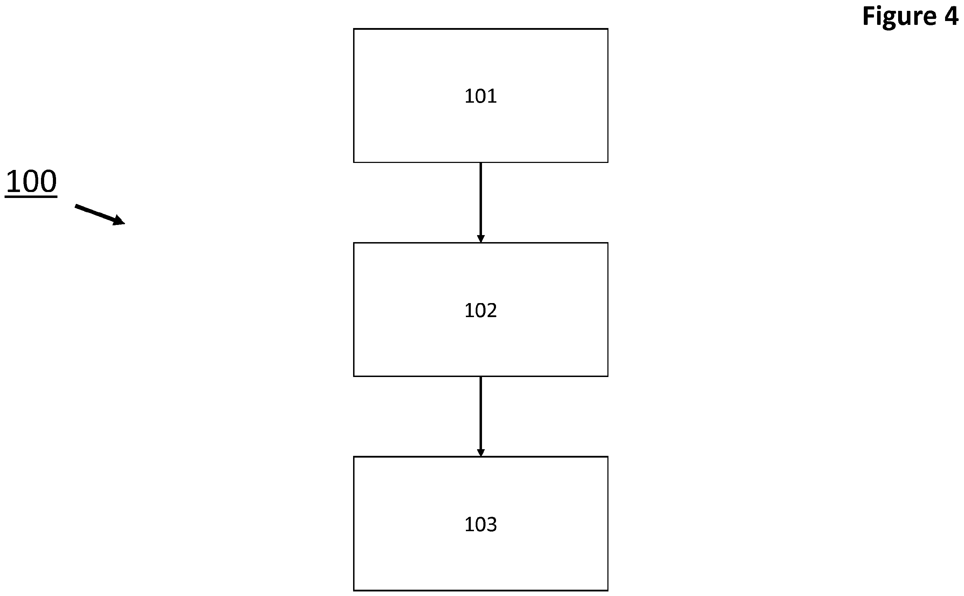

La figure 4 illustre schématiquement les différentes étapes du procédé 100 selon l'invention.

Le procédé 100 selon l'invention vise la mise en œuvre d'une technique de caractérisation par microscopie électronique à balayage pour la détermination d'au moins une dimension critique de la structure d'un échantillon dans le domaine de la métrologie dimensionnelle. Une application peut être par exemple la mesure d'une dimension critique d'un motif formant un circuit imprimé en microélectronique. La forme du motif peut être quelconque. Le matériau du motif peut être également quelconque. Ce motif peut être par exemple un motif isolé ou appartenant à un réseau de motifs répétés périodiquement. Il peut s'agir d'un motif obtenu après n'importe quelle étape (lithographie, gravure,...) d'un procédé de fabrication.

Une étape 101 du procédé 100 selon l'invention consiste à réaliser une image représentative de la structure de l'échantillon et issue d'un microscope électronique à balayage.

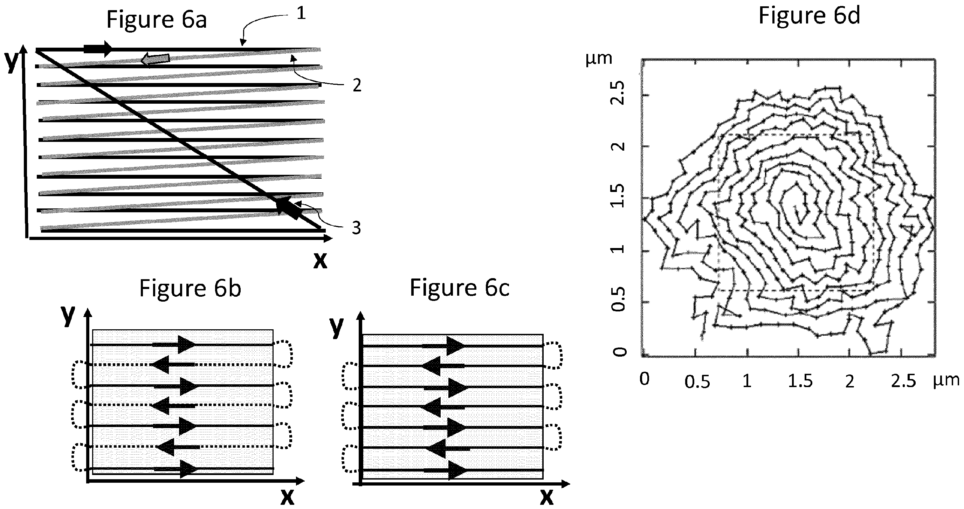

Selon un mode de réalisation préférentiel de l'étape 101 selon l'invention, le faisceau d'électrons primaires balaye l'échantillon suivant la méthode dite mode TV (ou « raster scan » en anglais). Ce mode de balayage est représenté par la figure 6a. Selon ce mode de balayage on peut identifier une direction de balayage rapide selon la direction x indiquée sur la figure 6a et une direction de balayage lente selon la direction y indiquée sur la figure 6a. Selon cette méthode de balayage, l'acquisition des données a lieu seulement en correspondance des traits horizontaux, indiqués (1) sur la figure 6a. Dans ce qui suit on se référera à la direction de balayage rapide, x sur la figure 6a, comme à la direction de balayage du faisceau d'électrons primaires.

Selon un autre mode de réalisation de l'étape 101 selon l'invention, le faisceau d'électrons primaires balaye l'échantillon suivant la méthode dite en dent de scie. Ce mode de balayage est représenté par la figure 6b. Sur cette figure, le trait plein représente la phase d'acquisition des données (donc de formation de l'image), le trait en pointillé désignant la phase de simple déplacement du faisceau d'électrons primaires sans acquisition des données. Les flèches en gris représentent le sens de balayage du faisceau d'électrons primaires.

Selon un autre mode de réalisation de l'étape 101 selon l'invention, le faisceau d'électrons primaires balaye l'échantillon suivant la méthode dite bidirectionnelle. Ce mode de balayage est représenté par la figure 6c. Sur cette figure, le trait plein représente la phase d'acquisition des données (donc de formation de l'image). A la différence des figures 6a et 6b, dans ce cas l'acquisition des données est faite en balayant la surface à la fois dans le sens des valeurs croissantes de la cordonnée x et dans le sens des valeurs décroissantes de la cordonnée x. Les flèches en gris représentent le sens de balayage du faisceau d'électrons primaires.

Selon un autre mode de réalisation de l'étape 101 selon l'invention, le faisceau d'électrons primaires balaye l'échantillon suivant une méthode adaptée à la forme des objets à caractériser. Ce mode de balayage est représenté par la figure 6d.

Selon une étape 102 du procédé 100 selon l'invention, à partir d'un modèle théorique paramétrique de la surface de l'échantillon on calcule un second modèle théorique capable de prendre en compte les altérations d'intensité de type marques sombres, comme celles présentes dans le prolongement des arêtes et ayant souvent la forme de trainées noires.

Plus précisément, l'étape 102 du procédé 100 selon l'invention comporte la modification d'un premier modèle théorique appelé $G(x,y)$ pour obtenir un second modèle théorique appelé $Img(x,y)$. Le modèle $G(x,y)$ est un modèle paramétrique de la réponse du microscope à la structure de l'échantillon obtenu par exemple par une des méthodes exposées dans les articles « CD characterization of nanostructures in SEM metrology » (C. G. Frase, E. Buhr, et K. Dirscherl, Meas. Sci. Technol., vol. 18, n° 2, p. 510, février. 2007) ou « Analytical Linescan Model for SEM Metrology » (C. A. Mack et B.D. Bunday, Metrology, Inspection and Process Control for Microlitography XXIX, Proc. SPIE Vol. 9424 2015) ou AMAT ou autre. La fonction G(x,y) représente donc une image théorique de la structure de l'échantillon sans effets liés au sens de balayage. Par exemple, l'image théorique sans effet de balayage G(x,y) est obtenue par l'application du modèle M(δ(x,y)) où δ(x,y) est la distance signée aux arrêtes de l'objet imagé. A l'instar de la fonction $M(x)$, ce modèle théorique contient un jeu de paramètres à déterminer et représentant à la fois les informations sur la géométrie de l'échantillon et sur la réponse instrumentale sans la prise en compte du sens de balayage.

Ensuite le second modèle théorique, $Img(x,y)$, est calculé. Ledit second modèle théorique est obtenu par somme algébrique d'un terme correctif au premier modèle théorique, ledit terme correctif étant un produit de convolution entre un noyau de convolution donné et le premier modèle théorique.

Selon un mode de réalisation de l'étape 102 du procédé 100 selon l'invention, le second modèle théorique est calculé selon la formule suivante (1):

$$Img(x,y) = G(x,y) - C \iint_{-\infty}^{+\infty} F(x',y') * [G(x',y') - \bar{G}_0]dx'dy'$$

Dans laquelle :

- $G(x,y)$ est le premier modèle théorique basé sur des fonctions mathématiques paramétriques ;
- (x,y) sont les cordonnées spatiales associées à chaque point de l'image suivant les deux directions orthogonales x et y;
- $Img(x,y)$ est le second modèle théorique obtenu par l'application du terme correctif ;
- $F(x, y)$ est le noyau de convolution donné ;
- $\bar{G}_0$ est la moyenne (« background » en anglais) des intensités présentes sur l'image expérimentale ;
- C est une constante d'ajustement.

Un avantage de ce mode de réalisation provient dans la formule (1) du produit de convolution calculé entre le noyau $F(x,y)$ et la différence $G(x',y') - \bar{G}_0$. La soustraction de l'intensité moyenne $\bar{G}_0$ permet en effet d'annuler le produit de convolution là où la réponse est constante, et donc le terme correctif, quand $G(x',y') = \bar{G}_0$. Cette condition est vérifiée pour les points de la surface de l'échantillon qui sont éloignés des motifs, donc pour des portions de l'image sur lesquelles les trainées noires ne sont pas présentes et pour lesquelles la correction n'est pas nécessaire.

De façon générale, le noyau de convolution F(x,y) est une fonction des cordonnées spatiales (x,y) ou bien des cordonnées spatiales choisies selon un quelconque système de cordonnées.

La présente invention peut être implémentée avec une fonction F(x,y) quelconque, à condition que le résultat de la formule (1) présentée plus haut soit bien défini. A titre d'exemple, selon les différents modes de réalisation de la présente invention, des noyaux de convolution symétriques, asymétriques ou anisotropes peuvent être utilisés.

Selon un mode de réalisation de l'étape 102 du procédé 100 selon l'invention, le faisceau d'électrons balaye la surface de l'échantillon selon la méthode dite balayage TV (« raster scan » en anglais) illustrée par la figure 6a.

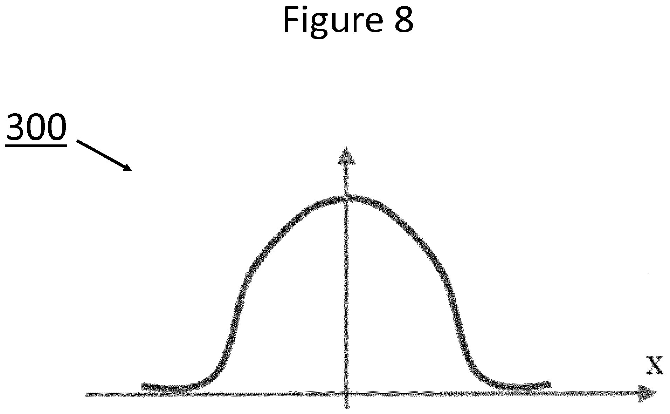

Selon un mode de réalisation de l'étape 102, le noyau de convolution est une fonction monodimensionnelle symétrique selon une direction de l'espace. La figure 8 montre un exemple de noyau symétrique 300 au sens de l'invention.

Selon un mode de réalisation de l'étape 102, le noyau de convolution est une gaussienne portée selon l'axe x, ledit axe x correspondant à la direction de balayage du faisceau d'électrons primaires, ladite gaussienne ayant une largeur à mi-hauteur proportionnelle à sigma, selon la formule suivante :

$$Img(x,y) = G(x,y) - C \int_{-\infty}^{+\infty} e^{-\frac{(x-x')^2}{2\sigma^2}} * [G(x',y) - \bar{G}_0]dx'$$

On remarque que dans ce cas le noyau de convolution $F(x',y')$ est une fonction constante selon la direction verticale y', ce qui explique pourquoi la variable y' n'apparaît pas dans le produit de convolution.

Un avantage de ce mode de réalisation est d'être particulièrement adapté à la prise en compte des baisses d'intensité dans le prolongement des arêtes dans la direction horizontale dans le cas de balayage en mode TV.

Selon un mode de réalisation de l'étape 102 du procédé 100 selon l'invention le noyau de convolution est une fonction bidimensionnelle symétrique.

Selon un mode de réalisation de l'étape 102 du procédé 100 selon l'invention, le noyau de convolution est symétrique dans les directions respectivement parallèle et normale à la direction de balayage du faisceau d'électrons primaires selon la formule suivante :

$$Img(x,y) = G(x,y) - C \iint_{-\infty}^{+\infty} e^{-\frac{(x-x')^2}{2\sigma_x^2}} e^{-\frac{(y-y')^2}{2\sigma_y^2}} * [G(x',y') - \bar{G}_0] dx' dy'$$

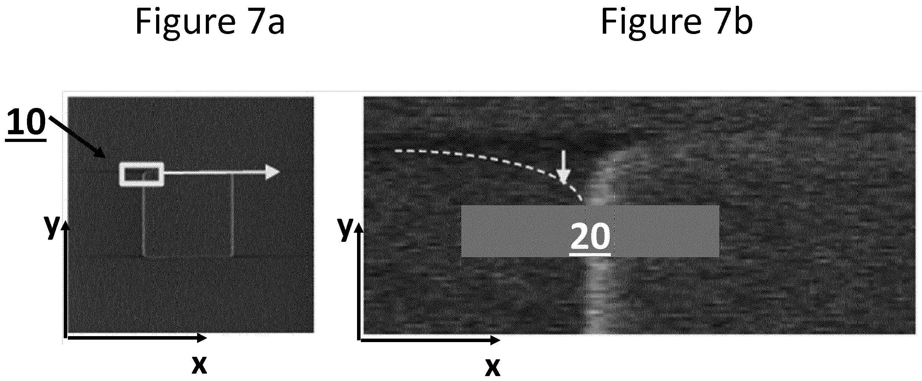

Un avantage de ce mode de réalisation est de pouvoir choisir un noyau de convolution capable de rendre compte des effets locaux particuliers, par exemple ceux en correspondance des coins des motifs formant la structure de l'échantillon. Les figures 7a et 7b illustrent un exemple de ces effets. La figure 7a est une image CD-SEM d'une structure de forme carrée. La figure 7b représente un agrandissement de la portion encadrée 10 de la figure 7a. Sur cette figure on peut voir un exemple particulier de marque sombre indiqué par la ligne en pointillé 20. Plus particulièrement on peut reconnaître une dépendance en y, qui s'ajoute à la dépendance en x. Ces observations motivent la nécessité d'un noyau de convolution bidimensionnel et éventuellement anisotrope suivant les deux directions orthogonales x et y. On entend par noyau de convolution anisotrope une fonction bidimensionnelle ayant un profil en x différent du profil en y (par exemple une gaussienne bidimensionnelle avec largeur $\sigma_x$ différente de la largeur $\sigma_y$)

Un autre avantage de ce mode de réalisation est de pouvoir être adapté à une méthode de balayage différente du mode TV.

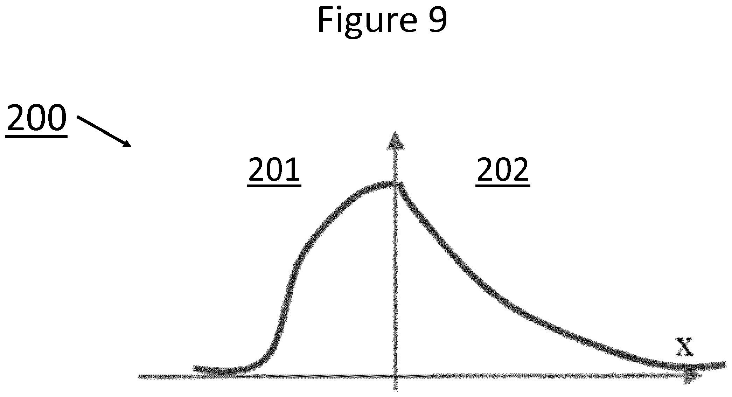

Selon un mode de réalisation de l'étape 102 du procédé 100 selon l'invention, le noyau de convolution a un profil asymétrique selon au moins une des directions x ou y. Un exemple est illustré par la figure 9 où l'on voit un exemple de noyau 200 de convolution asymétrique selon l'axe x. Dans ce cas on a, par exemple, un profil qui est en partie gaussien 201 et en partie décroissant suivant une dépendance en x non gaussienne 202.

Un avantage de ce mode de réalisation est de pouvoir adapter le noyau de convolution au mode de balayage employé et au type de motifs présents sur l'échantillon.

Selon une étape 103 du procédé 100 selon l'invention l'ajustement entre la formule (1) et l'image expérimentale est réalisé. Cet ajustement permet de trouver le jeu de paramètres présents en (1) qui minimise les écarts entre le modèle théorique et l'image expérimentale, par exemple en utilisant un des algorithmes connus qui appliquent la méthode des moindres carrés. A l'instar du modèle *G(x,y)*, le modèle *Img(x,y)* contient plusieurs paramètres, y-compris les paramètres décrivant la géométrie de l'échantillon et utilisés pour dériver la dimension critique d'intérêt.

Selon un mode de réalisation de l'étape 103 du procédé selon l'invention on réalise une étape de calibration pour déterminer les paramètres présents dans le modèle et liés à la réponse instrumentale. Ces paramètres font partie du jeu de paramètres déjà présents dans le premier modèle théorique et ils prennent en compte, par exemple, le fait que le faisceau d'électrons primaires a une taille non nulle. Souvent la forme du faisceau d'électrons primaires est décrite comme un profil gaussien. Cette fonction gaussienne prenant en compte les caractéristiques du faisceau d'électrons primaires est appelée « point spread function » en anglais ou PSF. Les paramètres décrivant la réponse instrumentale, par exemple les paramètres de la fonction PSF, peuvent avantageusement être déterminés lors d'une étape préliminaire de calibration. La calibration est obtenue en réalisant un ajustement entre la formule (1) et l'image expérimentale d'un échantillon dont la structure est connue. Cela permet de fixer les paramètres géométriques lors de l'étape de calibration et d'obtenir de façon plus fiable les paramètres décrivant la réponse instrumentale. Les valeurs des paramètres décrivant la réponse instrumentale seront ensuite fixées lors de la mise en œuvre de la technique CD-SEM pour la caractérisation d'une image expérimentale d'intérêt.

Un avantage de la réalisation de l'étape de calibration est de pouvoir déterminer de façon plus précise et fiable les paramètres décrivant la réponse instrumentale. Ensuite ces paramètres décrivant la réponse instrumentale seront fixés lors de la mise en œuvre de la technique CD-SEM pour la caractérisation d'une image expérimentale d'intérêt, ce qui permet d'atteindre une détermination plus précise et fiable des paramètres décrivant la structure de l'échantillon et donc des dimensions critiques d'intérêt

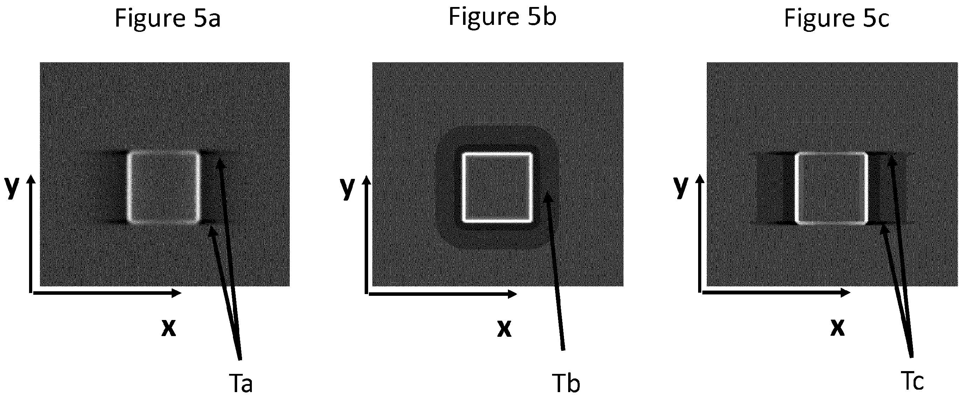

Les figures 5a à 5c illustrent les effets obtenus grâce au procédé selon l'invention. La figure 5a est une image CD-SEM d'un échantillon que l'on veut caractériser. Dans cet exemple on considère le cas d'un balayage en mode TV (« raster scan » en anglais). Selon ce mode de balayage, illustré à la figure 6a, le faisceau d'électrons primaires balaye rapidement la surface de l'échantillon suivant la direction x et plus lentement suivant la direction y. Dans ce cas on désigne la direction x simplement comme la direction de balayage du faisceau d'électrons primaires. Le repère Ta indique les trainées noires dans le prolongement des arêtes horizontales, suivant la direction de balayage. Ces artéfacts sont très fréquents sur les images CD-SEM obtenues avec cette méthode de balayage. La figure 5b représente le modèle théorique de l'image CD-SEM basé sur des fonctions paramétriques, ce qu'on a désigné *G(x,y)* plus haut. Le repère Tb indique les marques sombres qui sont prédites par ce type de modèle. On voit sur cette figure comment l'intensité de ces marques sombres est dépendante uniquement de la distance aux arêtes. De plus, aucune trainée noire du type indiqué par les flèches Ta n'est présente. La figure 5c représente le modèle théorique de l'image CD-SEM calculé au moyen du procédé selon l'invention, à l'aide de la formule suivante :

$$Img(x,y) = G(x,y) - C \int_{-\infty}^{+\infty} e^{-\frac{(x-x')^2}{2\sigma^2}} * [G(x',y) - \bar{G}_0] dx'$$

Le noyau de convolution choisi dans ce cas est une gaussienne unidimensionnelle portée selon l'axe x. L'image 5c issue du procédé selon l'invention reproduit les caractéristiques de l'image expérimentale 5a de façon plus précise par rapport au modèle théorique issu des fonctions paramétriques (image 5b). Plus précisément, sur l'image 5c, on peut voir des trainées noires, indiquées par les flèches Tc, qui reproduisent les trainées noires observées sur l'image CD-SEM 5a. Ces images montrent comment le procédé selon l'invention reproduit précisément les artéfacts de type marques sombres ou trainées noires dans le prolongement des arêtes suivant la direction de balayage du faisceau d'électrons primaires.

La mise en œuvre du procédé selon l'invention montrée sur les figures 5a, 5b et 5c peut également être accompagnée par une étape de calibration permettant d'obtenir de façon précise les paramètres décrivant la réponse instrumentale du microscope électronique à balayage. Pour ce faire il faut préalablement acquérir une image CD-SEM expérimentale d'un échantillon de référence dont les dimensions géométriques sont connues. Cette image est l'image de référence pour l'étape de calibration. Un ajustement entre le second modèle théorique et l'image de référence est ensuite réalisé, en fixant les paramètres géométriques, qui sont connus dans le cas de l'échantillon de référence. Cet ajustement permet d'obtenir les valeurs des paramètres décrivant la réponse instrumentale, par exemple les paramètres de la fonction PSF, ou l'amplitude des signaux. Le fait d'avoir fixé les paramètres géométriques lors de cette étape de calibration permet d'obtenir de façon plus fiable et précise les paramètres décrivant la réponse instrumentale. Les valeurs desdits paramètres décrivant la réponse instrumentale seront ensuite fixées lors de la mise en œuvre du procédé selon l'invention sur un échantillon d'intérêt.

## Revendications

1. Procédé (100) de mise en œuvre d'une technique de caractérisation par microscopie électronique à balayage pour la détermination d'au moins une dimension critique de la structure d'un échantillon dans le domaine de la métrologie dimensionnelle, dite technique CD-SEM, ledit procédé comportant les étapes suivantes :

   - réalisation (101) d'une image expérimentale représentative de la structure de l'échantillon et issue d'un microscope électronique à balayage ;
   - à partir d'un premier modèle théorique basé sur des fonctions mathématiques paramétriques, calcul (102) d'un second modèle théorique obtenu par somme algébrique d'un terme correctif, ledit terme correctif étant le produit de convolution entre un noyau de convolution donné et le premier modèle théorique, ledit second modèle théorique comportant un jeu de paramètres à déterminer, le premier et second modèle théorique étant une représentation mathématique de la structure de l'échantillon dans l'image expérimentale ;
   - détermination (103) du jeu de paramètres présents dans le second modèle théorique au moyen d'un ajustement entre ledit second modèle théorique et ladite image expérimentale, l'ajustement correspondant à une minimisation d'un écart entre ledit second modèle théorique et ladite image expérimentale.

2. Procédé (100) selon la revendication précédente **caractérisé en ce que** le second modèle théorique est calculé selon la formule suivante :

$$Img(x,y) = G(x,y) - C \iint_{-\infty}^{+\infty} F(x',y') * [G(x',y') - \bar{G}_0] dx' dy'$$

dans laquelle :

   (x,y) sont les cordonnées spatiales associées à chaque point de l'image suivant les deux directions orthogonales x et y ;
   G(x,y) est le premier modèle théorique basé sur des fonctions mathématiques paramétriques ;
   Img(x,y) est le second modèle théorique obtenu par l'application du terme correctif;
   F(x, y) est le noyau de convolution donné ;
   $\bar{G}_0$ est la moyenne (« background » en anglais) des intensités présentes sur l'image expérimentale ;
   C est une constante d'ajustement ;

3. Procédé (100) selon l'une des revendications précédentes **caractérisé en ce que** le faisceau d'électrons primaires balaye la surface de l'échantillon suivant la méthode de balayage dite TV ou « raster scan » en anglais, la direction de balayage étant la direction horizontale ou axe x.

4. Procédé (100) selon l'une des revendications précédentes **caractérisé en ce que** le noyau de convolution est une fonction monodimensionnelle symétrique.

5. Procédé (100) selon la revendication 2 et la revendication 4 **caractérisé en ce que** le noyau de convolution est une gaussienne portée selon l'axe x, ladite gaussienne ayant une largeur à mi-hauteur proportionnelle à sigma selon la formule suivante :

$$Img(x,y) = G(x,y) - C \int_{-\infty}^{+\infty} e^{-\frac{(x-x')^2}{2\sigma^2}} * [G(x',y) - \bar{G}_0]dx'$$

6. Procédé (100) selon l'une des revendications 1 à 3 **caractérisé en ce que** le noyau de convolution est une fonction bidimensionnelle symétrique.

7. Procédé (100) selon la revendication 2 et la revendication 6 **caractérisé en ce que** le noyau de convolution est bidimensionnel symétrique dans les directions respectivement parallèle et normale à la direction de balayage du faisceau d'électrons primaires selon la formule suivante :

$$Img(x,y) = G(x,y) - C \iint_{-\infty}^{+\infty} e^{-\frac{(x-x')^2}{2\sigma_x^2}} e^{-\frac{(y-y')^2}{2\sigma_y^2}} * [G(x',y') - \bar{G}_0]dx'dy'$$

8. Procédé (100) selon l'une des revendications 1 à 3 **caractérisé en ce que** le noyau de convolution a un profil monodimensionnel asymétrique suivant la direction de balayage du faisceau d'électrons primaires ou un profil bidimensionnel asymétrique suivant la direction de balayage du faisceau d'électrons primaires.

9. Procédé selon l'une des revendications 1 à 8, ledit procédé étant mis en œuvre pour une calibration de la technique de caractérisation CD-SEM, ladite calibration comportant les étapes suivantes :

- Réalisation d'une image expérimentale représentative de la structure d'un échantillon de référence dont les dimensions géométriques sont connues, ladite image issue d'un microscope électronique à balayage ;
- à partir d'un premier modèle théorique basé sur des fonctions mathématiques paramétriques, calcul d'un second modèle théorique obtenu par somme algébrique d'un terme correctif, ledit terme correctif étant le produit de convolution entre un noyau de convolution donné et le premier modèle théorique, ledit second modèle théorique comportant un jeu de paramètres, ledit jeu de paramètres comprenant à la fois les paramètres connus qui décrivent la structure géométrique de l'échantillon de référence et les paramètres à déterminer qui décrivent la réponse instrumentale ;
- détermination des paramètres présents dans le second modèle théorique et décrivant la réponse instrumentale au moyen d'un ajustement entre ledit second modèle théorique et ladite image expérimentale représentative de la structure de l'échantillon de référence.

10. Procédé de mise en œuvre d'une technique de caractérisation CD-SEM selon l'une des revendications 1 à 8 et la revendication précédente, ledit procédé comportant les étapes suivantes :

- réalisation d'une image expérimentale représentative de la structure de l'échantillon et issue d'un microscope électronique à balayage ;
- à partir d'un premier modèle théorique basé sur des fonctions mathématiques paramétriques, calcul d'un second modèle théorique obtenu par somme algébrique d'un terme correctif, ledit terme correctif étant le produit de convolution entre un noyau de convolution donné et le premier modèle théorique, ledit second modèle théorique comportant un jeu de paramètres, ledit jeu de paramètres comprenant à la fois les paramètres à déterminer qui décrivent la structure géométrique de l'échantillon d'intérêt et les paramètres déterminés selon la calibration selon la revendication précédente qui décrivent la réponse instrumentale ;
- détermination des paramètres présents dans le second modèle théorique et décrivant la structure de l'échantillon d'intérêt au moyen d'un ajustement entre ledit second modèle théorique et ladite image expérimentale.

**Patentansprüche**

1. Verfahren (100) zum Umsetzen einer Charakterisierungstechnik per Rasterelektronenmikroskop für die Bestimmung wenigstens einer kritischen Dimension der Struktur einer Probe im Bereich der dimensionellen Messtechnik, bezeichnet als CD-SEM, wobei das genannte Verfahren die folgenden Schritte umfasst:

   - Realisierung (101) eines experimentellen Bildes, das die Struktur der Probe darstellt und aus einem Rasterelektronenmikroskop stammt;
   - ausgehend von einem ersten theoretischen Modell, das auf parametrischen mathematischen Funktionen basiert, Berechnung (102) eines zweiten theoretischen Modells, das per Algebrasumme eines Korrekturterms erhalten wird, wobei der genannte Korrekturterm das Konvolutionsprodukt zwischen einem gegebenen Konvolutionskern und dem ersten theoretischen Modell ist, wobei das zweite theoretische Modell einen zu bestimmenden Parametersatz umfasst, wobei das erste und das zweite theoretische Modell eine mathematische Darstellung der Struktur der Probe in dem experimentellen Bild sind;
   - Bestimmung (103) des Satzes der Parameter, die in dem zweiten theoretischen Modell vorhanden sind, mittels einer Anpassung zwischen dem genannten zweiten theoretischen Modell und dem genannten experimentellen Bild, wobei die Anpassung einer Minimierung einer Abweichung zwischen dem genannten zweiten theoretischen Modell und dem genannten experimentellen Bild entspricht.

2. Verfahren (100) gemäß dem voranstehenden Anspruch, **dadurch gekennzeichnet, dass** das zweite theoretische Modell gemäß der folgenden Formel berechnet wird:

$$Img(x,y) = G(x,y) - C \iint_{-\infty}^{+\infty} F(x',y') * [G(x',y') - \bar{G}_0]dx'dy'$$

wobei:

   $(x, y)$ die räumlichen Koordinaten sind; die jedem Punkt des Bildes gemäß den zwei orthogonalen Richtungen x und y zugeordnet sind;
   $G(x, y)$ das erste theoretische Modell ist, das auf den parametrischen mathematischen Funktionen basiert;
   $Img(x, y)$ das zweite theoretische Modell ist, das von der Anwendung des Korrekturterms erhalten wird;
   $F(x, y)$ der bestimmte Konvolutionskern ist;
   $\bar{G}_0$ das Mittel (im Englischen "Background") der Intensitäten ist, die in dem experimentellen Bild vorhanden sind;
   C eine Anpassungskonstante ist.

3. Verfahren gemäß einem der voranstehenden Ansprüche, **dadurch gekennzeichnet, dass** das Bündel aus primären Elektronen die Oberfläche der Probe gemäß dem Abtastverfahren, bezeichnet als TV oder "Raster Scan" im Englischen abtastet, wobei die Abtastrichtung die horizontale Richtung oder die x-Achse ist.

4. Verfahren gemäß einem der voranstehenden Ansprüche, **dadurch gekennzeichnet, dass** der Konvolutionskern eine symmetrische, eindimensionale Funktion ist.

5. Verfahren gemäß Anspruch 2 und Anspruch 4, **dadurch gekennzeichnet, dass** der Konvolutionskern ein Gaußscher Bereich gemäß der x-Achse ist, wobei der genannte Gaußsche Bereich eine Breite auf der halben proportionalen Sigmahöhe gemäß der folgenden Formel aufweist:

$$Img(x,y) = G(x,y) - C \int_{-\infty}^{+\infty} e^{-\frac{(x-x')^2}{2\sigma^2}} * [G(x',y) - \bar{G}_0]dx'$$

6. Verfahren (100) gemäß einem der Ansprüche 1 bis 3, **dadurch gekennzeichnet, dass** der Konvolutionskern eine symmetrische zweidimensionale Funktion ist.

7. Verfahren (100) gemäß Anspruch 2 und Anspruch 6, **dadurch gekennzeichnet, dass** der Konvolutionskern in der jeweils parallelen und der normalen Richtung zur Abtastrichtung des Bündels aus primären Elektronen gemäß der folgenden Formel symmetrisch und zweidimensional ist:

$$Img(x,y) = G(x,y) - C \iint_{-\infty}^{+\infty} e^{-\frac{(x-x')^2}{2\sigma_x^2}} e^{-\frac{(y-y')^2}{2\sigma_y^2}} * [G(x',y') - \bar{G}_0]dx'dy'$$

8. Verfahren (100) gemäß einem der Ansprüche 1 bis 3, **dadurch gekennzeichnet, dass** der Konvolutionskern ein asymmetrisches, eindimensionales Profil gemäß der Abtastrichtung des Bündels aus primären Elektronen oder ein asymmetrisches, zweidimensionales Profil gemäß der Abtastrichtung des Bündels aus primären Elektronen aufweist.

9. Verfahren gemäß einem der Ansprüche 1 bis 8, wobei das genannte Verfahren für eine Kalibrierung der Charakterisierungstechnik CD-SEM umgesetzt wird, wobei die genannte Kalibrierung die folgenden Schritte umfasst:

- Herstellung eines experimentellen Bildes, das die Struktur einer Referenzprobe darstellt, deren geometrische Abmessungen bekannt sind, wobei das genannte Bild aus einem Rasterelektronenmikroskop stammt;
- ausgehend von einem ersten theoretischen Modell, das auf parametrischen mathematischen Funktionen basiert, Berechnung eines zweiten theoretischen Modells, das per Algebrasumme eines Korrekturterms erhalten wird, wobei der genannte Korrekturterm das Konvolutionsprodukt zwischen einem bestimmten Konvolutionskern und dem ersten theoretischen Modell ist, wobei das zweite theoretische Modell einen Parametersatz umfasst, wobei der Parametersatz gleichzeitig die bekannten Parameter, die die geometrische Struktur der Referenzprobe beschreiben, und die zu bestimmenden Parameter, die die instrumentale Antwort beschreiben, umfasst;
- Bestimmen der in dem zweiten theoretischen Modell vorhandenen Parameter, die die instrumentale Antwort mittels einer Anpassung zwischen dem genannten zweiten theoretischen Modell und dem genannten experimentellen Bild, das die Struktur der Referenzprobe darstellt, beschreibt.

10. Verfahren zum Umsetzen einer Charakterisierungstechnik CD-SEM gemäß einem der Ansprüche 1 bis 8 und dem voranstehenden Anspruch, wobei das genannte Verfahren die folgenden Schritte umfasst:

- Realisieren eines experimentellen Bildes, das die Struktur der Probe darstellt und aus einem Rasterelektronenmikroskop stammt;
- ausgehend von einem ersten theoretischen Modell, das auf parametrischen mathematischen Funktionen basiert, Berechnung eines zweiten theoretischen Modells, das per Algebrasumme eines Korrekturterms erhalten wird, wobei der genannte Korrekturterm das Konvolutionsprodukt zwischen einem bestimmten Konvolutionskern und dem ersten theoretischen Modell ist, wobei das genannte zweite theoretische Modell einen Parametersatz umfasst, wobei der genannte Parametersatz sowohl die zu bestimmenden Parameter, die die geometrische Struktur der betrachteten Probe beschreiben, und den gemäß der Kalibrierung gemäß dem voranstehenden Anspruch bestimmten Parametern, die die instrumentale Antwort beschreiben, umfasst;
- Bestimmen der Parameter; die in dem zweiten theoretischen Modell vorhanden sind und die Struktur der betrachteten Probe mittels einer Anpassung zwischen dem zweiten theoretischen Modell und dem genannten experimentellen Bild beschreiben.

**Claims**

1. Method (100) for implementing a scanning electron microscopy characterisation technique for the determination of at least one critical dimension of the structure of a sample in the field of dimensional metrology, known as CD-SEM technique, said method comprising the following steps:

- producing (101) an experimental image representative of the structure of the sample and derived from a scanning electron microscope;
- from a first theoretical model based on parametric mathematical functions, calculating (102) a second theoretical model obtained by algebraic summation of a corrective term, said corrective term being the convolution product between a given convolution kernel and the first theoretical model, said second theoretical model comprising a set of parameters to be determined, the first and second theoretical models being a mathematical representation of the structure of the sample in the experimental image;

- determination (103) of the set of parameters present in the second theoretical model by means of an adjustment between said second theoretical model and said experimental image, the adjustment corresponding to a minimisation of a difference between said second theoretical model and said experimental image.

2. Method (100) according to the preceding claim **characterised in that** the second theoretical model is calculated according to the following formula:

$$Img(x,y) = G(x,y) - C \iint_{-\infty}^{+\infty} F(x',y') * [G(x',y') - \bar{G}_0]dx'dy'$$

in which:

(x,y) are the spatial coordinates associated with each point of the image along the two orthogonal directions x and y;
$G(x, y)$ is the first theoretical model based on parametric mathematical functions;
$Img(x,y)$ is the second theoretical model obtained by using the corrective term;
$F(x, y)$ is the given convolution kernel;
$G_0$ is the average (the "background") of the intensities present on the experimental image;
C is an adjustment constant;

3. Method (100) according to one of the preceding claims **characterised in that** the primary electron beam scans the surface of the sample according to the so-called TV or raster scan method, the scanning direction being the horizontal direction or x axis.

4. Method (100) according to one of the preceding claims **characterised in that** the convolution kernel is a symmetrical one-dimensional function.

5. Method (100) according to claim 2 and claim 4 **characterised in that** the convolution kernel is a Gaussian taken along the x axis, said Gaussian having a full width at half maximum proportional to sigma, according to the following formula:

$$Img(x,y) = G(x,y) - C \int_{-\infty}^{+\infty} e^{-\frac{(x-x')^2}{2\sigma^2}} * [G(x',y) - \bar{G}_0]dx'$$

6. Method (100) according to one of claims 1 to 3 **characterised in that** the convolution kernel is a two-dimensional symmetrical function.

7. Method (100) according to claim 2 and claim 6 **characterised in that** the convolution kernel is two-dimensional symmetrical in the directions respectively parallel and normal to the scanning direction of the primary electron beam, according to the following formula:

$$Img(x,y) = G(x,y) - C \iint_{-\infty}^{+\infty} e^{-\frac{(x-x')^2}{2\sigma_x^2}} e^{-\frac{(y-y')^2}{2\sigma_y^2}} * [G(x',y') - \bar{G}_0]dx'dy'$$

8. Method (100) according to one of claims 1 to 3 **characterised in that** the convolution kernel has a mono-dimensional profile asymmetric along the scanning direction of the primary electron beam or a two-dimensional profile asymmetric along the scanning direction of the primary electron beam.

9. Method according to one of claims 1 to 8, said method being implemented for a calibration of the CD-SEM characterisation technique, said calibration comprising the following steps:

14

- producing an experimental image representative of the structure of a reference sample of which the geometric dimensions are known, said image derived from a scanning electron microscope;
- from a first theoretical model based on parametric mathematical functions, calculating a second theoretical model obtained by algebraic summation of a corrective term, said corrective term being the convolution product between a given convolution kernel and the first theoretical model, said second theoretical model comprising a set of parameters, said set of parameters including both the known parameters which describe the geometric structure of the reference sample and the parameters to be determined which describe the instrumental response;
- determination of the parameters present in the second theoretical model and describing the instrumental response by means of an adjustment between said second theoretical model and said experimental image representative of the structure of the reference sample.

10. Method for implementing a CD-SEM characterisation technique according to one of claims 1 to 8 and the preceding claim, said method comprising the following steps:

- producing an experimental image representative of the structure of the sample and derived from a scanning electron microscope;
- from a first theoretical model based on parametric mathematical functions, calculating a second theoretical model obtained by algebraic summation of a corrective term, said corrective term being the convolution product between a given convolution kernel and the first theoretical model, said second theoretical model comprising a set of parameters, said set of parameters including both the parameters to be determined which describe the geometric structure of the sample of interest and the parameters determined according to the calibration according to the preceding claim which describe the instrumental response;
- determination of the parameters present in the second theoretical model and describing the structure of the sample of interest by means of an adjustment between said second theoretical model and said experimental image.

**Fig. 1**

Figure 2a

Figure 2b

M(x)

S0

S1

S2

S3

S0

X1  X2  X3  X4 X5

Figure 3c

Figure 3b

Figure 3d

Figure 3a

**Figure 4**

EP 3 555 848 B1

Figure 5a    Figure 5b    Figure 5c

Figure 6d

Figure 6c

Figure 6a

Figure 6b

Figure 7a

Figure 7b

Figure 8

300

x

# Figure 9

EP 3 555 848 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **C. G. FRASE ; E. BUHR ; K. DIRSCHERL.** CD characterization of nanostructures in SEM metrology. *Meas. Sci. Technol.,* Février 2007, vol. 18 (2), 510
- Analytical Linescan Model for SEM Metrology. **C. A. MACK ; B.D. BUNDAY.** Metrology, Inspection and Process Control for Microlitography XXIX. Proc. SPIE, 2015, vol. 9424
- **DE SHIMON LEVI.** SEM Simulation for 2D and 3D Inspection Metrology and Defect Review. *Ishai Schwarzband, Sergey Khristo, Yan Ivanchenko, Ofer Adan, Advances in Patterning Materials and Processes XXXI,* 2014